(19) Europäisches Patentamt / European Patent Office / Office européen des brevets

(11) **EP 3 413 066 A1**

(12) **EUROPEAN PATENT APPLICATION**

(43) Date of publication:
**12.12.2018 Bulletin 2018/50**

(51) Int Cl.:
***G01R 31/34*** *(2006.01)*     *G01R 31/14* *(2006.01)*

(21) Application number: **17174719.9**

(22) Date of filing: **07.06.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Siemens Aktiengesellschaft 80333 München (DE)**

(72) Inventor: **Zalud, Jan 26601 Beroun (CZ)**

(74) Representative: **Maier, Daniel Oliver Siemens AG Postfach 22 16 34 80506 München (DE)**

(54) **DETECTION OF FAILURES IN THE WINDINGS OF AN ELECTRICAL MACHINE**

(57) Method for detection of failures in the windings (U,V,W) of an electrical machine, the method including the following steps:
- measuring for a first area and for a second area of the windings different from the first area a physical quantity which is proportional to the electric current in the first area and in the second area, respectively,
- coupling the measured electrical signal representing the current ($I_{Uin}$) in the first area with the measured electrical signal representing the current ($I_{Uout}$) in the second area,
- obtaining a resulting electric signal proportional to the difference ($I_{diff}$) of both currents,
- issuing a failure notice if a value of the resulting signal exceeds a predefined threshold.

FIG 2

**Description**

FIELD OF THE INVENTION

The present invention relates to a method for detection of failures in the windings of an electrical machine, e. g. a motor, especially for detection of failures of the insulation of the windings.

Such electrical machine can be any electrical machine containing windings which are on different potentials, like a motor or a generator. The examined winding or windings can be part of the stator or part of the rotor. Regarding electrical motors, the method can be applied to asynchronous motors, like an induction motor, or to synchronous motors.

STATE OF THE ART

There currently are no practically used methods to detect, that is, to predict failures of the winding insulation. The research in this field is directed to so-called "amplitude detection methods". For example in an induction motor the stator current is measured and then mathematically analyzed. Such methods require precise current measurement and are very sensitive to common disturbances, such as to an unsymmetrical power supply network, to a temperature change or to variations in the supply voltage by a frequency inverter. The problem is that the leakage current, which is caused by the developing winding insulation failure, is very small compared to the working current of the winding, e.g. smaller by a factor of 1000. So detecting absolute variations in the amplitude of the current in the examined winding is not practicable since often not feasible.

SUMMARY OF THE INVENTION

One object of the present invention is to provide a method for detecting, including predicting, failures in the windings of an electrical machine already when they are developing but not yet causing a machine failure which method shall be less prone to common disturbances in the working current of the winding.

According to the present invention this method for detection of failures in the windings of an electrical machine, especially for detection of failures of the insulation of the windings, includes the following steps:

- measuring for a first area and for a second area of the windings different from the first area a physical quantity which is proportional to the electric current in the first area and in the second area, respectively,
- coupling the measured electrical signal representing the current in the first area with the measured electrical signal representing the current in the second area,
- obtaining a resulting electric signal proportional to the difference of both currents,
- issuing a failure notice if a value of the resulting signal exceeds a predefined threshold.

The method according to the invention allows for discovering irregularities in the currents flowing through different parts of the winding of the electrical machine. Such irregularities are mostly caused by winding insulation faults.

This approach does not include measurement of the total amplitude of the input or output current, but a measurement of the difference between input and output current. The method according to the invention is a differential measurement. As a result the "normal" machine behavior, and thus any common disturbance, is filtered out from the measured values by the nature of the method according to the invention and only a possible imbalance, e.g. due to a failure of the insulation of the respective winding, is directly measured. So the quality of the signal resulting after coupling the measured electrical signal representing the input current with the measured electrical signal representing the output current has a higher quality than a signal obtained by a measurement of the total current amplitude ("amplitude detection method"). Accordingly, more simple evaluation electronics can be used. The need for filtering out common disturbances, e.g. due to an unsymmetrical power supply network, to a temperature change or to ageing of the magnetic material of the electrical machine, is at least reduced.

Due to the higher signal quality of the resulting signal, which is proportional to the failure current, the method according to the invention can be used to already detect small failures in the winding insulation, which failures do not yet cause problems for the performance of the electrical machine, and thus predict that in future a major failure will occur, due to development of the small failures. The major failures would then affect the performance of the electrical machine.

Due to the prediction of winding failures unscheduled downtimes can be prevented. If a major failure is predicted the electrical machine can be disconnected from the power grid, e.g. using circuit breakers, during a scheduled downtime and can be replaced by another electrical machine.

Due to the higher sensitivity of the method according to the invention the method can also be used for large electrical machines.

The method according to the invention does hardly need changes in the construction of the electrical machine.

Only a small measurement and diagnostic tool has to be added.

The software for evaluating if a value of the resulting signal exceeds a predefined threshold and if so, for issuing a failure notice, can be kept simple. For example, a simple low pass filter and a low frequency FFT can be applied to the resulting signal.

A first embodiment of the method according to the invention comprises the steps of

- measuring for the input side and for the output side of the same winding a physical quantity which is proportional to the electric current on the input side and on the output side, respectively,
- coupling the measured electrical signal representing the input current with the measured electrical signal representing the output current,
- obtaining a resulting electric signal proportional to the difference of input current and output current,
- issuing a failure notice if a value of the resulting signal exceeds a predefined threshold.

This first embodiment consists of measuring whether the current flowing into the winding is the same as the current flowing out of the winding, or if they differ by the current that leaked into (or out of) the winding from another phase winding. Whatever way the two currents are measured the quantity evaluated against a chosen threshold to detect a winding failure is proportional to the summary current $I_{sum} = I_{in} + I_{out}$ which in a healthy machine, e.g. motor, yields 0. In case some current is leaking through the insulation of the phase winding, it will be read because $I_{sum}$ will not equal 0.

The quality of the components used for indirectly measuring the electric current on the input side and on the output side of the winding do not need to work as precise as for "amplitude detection methods".

Of course the method according to the first embodiment of the invention can be applied to one, more or all windings of an electrical machine at the same time, as well as, for example, to individual sub-windings constituting one winding, if one sub-winding has an individual input and output side on which the measurement can take place.

The method can be applied to detect leakage currents from one winding to another winding or from within one winding or from a winding to a housing of the electrical machine.

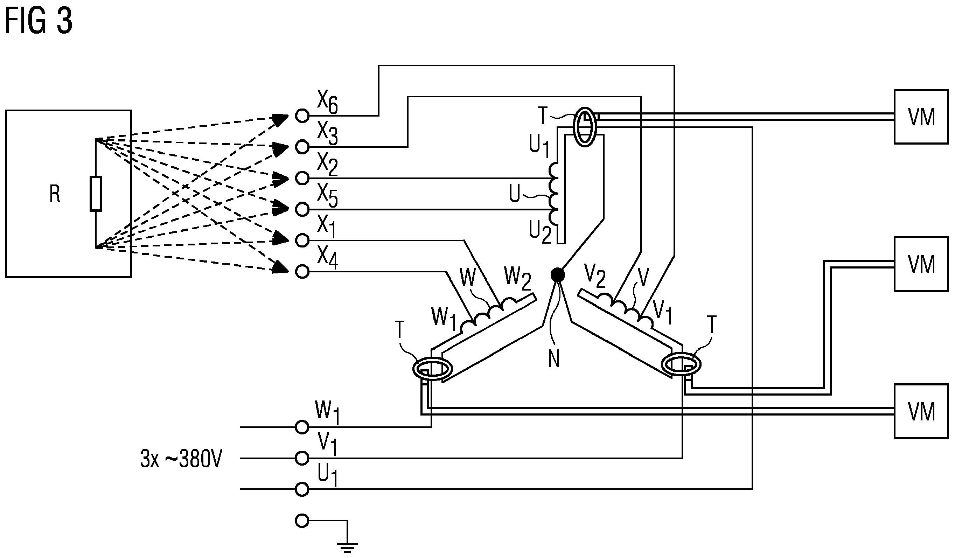

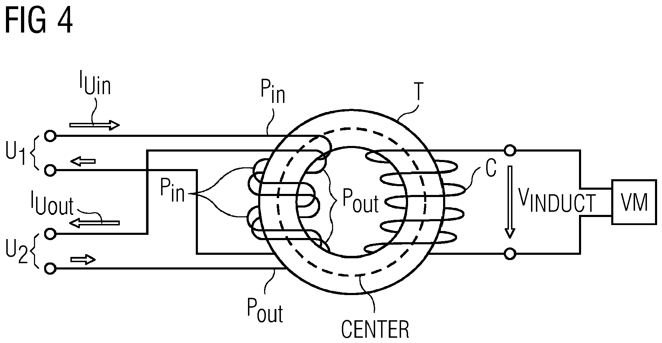

One embodiment of this first embodiment is that the measured physical quantity which is proportional to the electric current on the input side and on the output side is the voltage, especially the voltage induced in a coil. A measurement coil can be placed near or around the wire which carries the input current into the winding, another measurement coil can be placed near or around the wire which carries the output current out of the same winding. The voltage induced in the measurement coils is proportional to the input and output current, respectively. Or the wire which carries the input current into the winding forms a measurement coil and another wire which carries the output current into the winding forms another measurement coil (see Fig. 3,4).

There are at least two possibilities how to couple the measured electrical signal representing the input current with the measured electrical signal representing the output current.

The first possibility is that for coupling the measured electrical signal representing the input current with the measured electrical signal representing the output current a first measurement coil at the input side and a second measurement coil at the output side being connected in series are used.

The second possibility is that for coupling the measured electrical signal representing the input current with the measured electrical signal representing the output current a first measurement coil for the input current and a second measurement coil for the output current of the same winding are wound around the same transformer core to implement a differential transformer.

A second embodiment of the method according to the invention comprises the steps of

- measuring a first magnetic flux for a first area of the windings and a second magnetic flux for a second area of the windings which second area - in relation to the axis of the electrical machine - is situated symmetrical to the first area,
- coupling the measured electrical signal representing the magnetic flux in the first area with the measured electrical signal representing the magnetic flux in the second area,
- obtaining a resulting electric signal proportional to the difference of first and second magnetic flux,
- issuing a failure notice if a value of the resulting signal exceeds a predefined threshold.

The measured physical quantity which is proportional to the electric current again can be the voltage, especially the voltage induced in a coil.

Here the magnetic flux which originates from the current in the windings is measured. The method consists e. g. of adding one or more pairs of additional winding coils as measurement coils into the electric machine winding. The pair of measurement coils is best wound symmetrically to the machine axis. The windings of each symmetrical pair are wound so that the magnetic flux of a healthy machine induces voltage Uind1 in the first additional coil and Uind2 in the second additional coil. Resulting voltage when the two additional coils are connected in series is + Uind1(t) + Uind2 (t) = 0. In case there is a failure in the insulation of the machine and therefore there are currents leaking somewhere through the winding, they do not anymore produce an axis symmetrical magnetic flux in the machine. The voltages in the two additional coils are not equal and the winding fault can be detected if the voltage $U_{diff}$ exceeds a chosen threshold $U_{diff}$ = Uind1 - Uind2.

Whatever way the magnetic flux is measured in the machine, the quantity evaluated against a chosen threshold is proportional to the $\Phi_{sum} = \Phi1 + \Phi2$ which in a healthy machine yields 0 because the fluxes are equal in amplitude and induce voltages into the additional windings with opposite signs (Uind1 + Uind2 = Usum = 0).

One embodiment of this second embodiment is that the magnetic flux, which is the measured physical quantity which is proportional to the electric current in this case, is the voltage, especially the voltage induced in a coil.

For all embodiments of the invention the resulting electric signal after coupling the two measured electrical signals has to be evaluated, that is, it has to be checked if a value of the resulting signal exceeds a predefined threshold. This value of the resulting signal can be a voltage. How this voltage value is obtained depends on the way how the voltage is measured. In case of the first embodiment of the invention, where the current flowing into the winding is compared to the current flowing out of the same winding, if the resulting signal is obtained by connecting two measurement coils in series, the resulting voltage can be measured with a voltmeter. Also when implementing a differential transformer the resulting voltage can simply be measured with a voltmeter.

In other cases, e.g. in case of the second embodiment of the invention when measuring the magnetic flux in a pair of symmetrically arranged measurement coils, the resulting voltage signal can be analyzed with regard to certain voltage components.

In this case the resulting signal can be transformed from the time domain into the frequency domain and the amplitude of the frequency component at the frequency of the power supply of the electrical machine is examined if it exceeds a predefined threshold.

For example, a simple low pass filter and a low frequency FFT can be applied to the resulting signal. If the transformation shows a peak at the frequency of the voltage supplied to the winding or the electrical machine, respectively, which peak is higher than a predefined threshold then some kind of failure notice is issued. If there is no peak at the frequency of the supply voltage of the winding, or a peak smaller than a predefined threshold, no failure notice is issued.

A possible electrical machine for detection of failures in its windings, which machine is adapted for carrying out a method according to the invention, includes at least

- measuring means configured for measuring for a first area and for a second area of the windings different from the first area a physical quantity which is proportional to the electric current in the first area and in the second area, respectively,
- coupling means configured for coupling the measured electrical signal representing the current in the first area with the measured electrical signal representing the current in the second area, and for obtaining a resulting electric signal proportional to the difference of both currents,
- evaluation means configured for issuing a failure notice if a value of the resulting signal exceeds a predefined threshold.

A first embodiment of such an electrical machine includes at least

- measuring means configured for measuring for the input side and for the output side of the same winding a physical quantity which is proportional to the electric current on the input side and on the output side, respectively,
- coupling means configured for coupling the measured electrical signal representing the input current with the measured electrical signal representing the output current, and for obtaining a resulting electric signal proportional to the difference of input current and output current,
- evaluation means configured for issuing a failure notice if a value of the resulting signal exceeds a predefined threshold.

A second embodiment of such an electrical machine includes at least

- measuring means configured for measuring a first magnetic flux for a first area of the windings and a second magnetic flux for a second area of the windings which second area - in relation to the axis of the electrical machine - is situated symmetrical to the first area,
- coupling means configured for coupling the measured electrical signal representing the magnetic flux in the first area with the measured electrical signal representing the magnetic flux in the second area, and for obtaining a resulting electric signal proportional to the difference of first and second magnetic flux,
- evaluation means configured for issuing a failure notice if a value of the resulting signal exceeds a predefined threshold.

With regard to all embodiments of the electrical machine the measuring means can comprise coils. According to the first embodiment of the invention the input current and the output current induce a voltage in the coils provided for the input side and the output side. According to the second embodiment of the invention, the current in the winding(s) of the machine build up a magnetic field which induces a voltage in one ore more pairs of symmetrically arranged measurement coils.

Of course the current of the winding(s) and/or the magnetic flux resulting therefrom can also be measured via devices different from coils, e.g. via current transducers. A current transducer could for example use the Hall effect. A Hall effect sensor varies its output voltage in response to a magnetic field.

According to the first embodiment of the invention the coupling means can comprise a series connection of a first measurement coil at the input side and a second measurement coil at the output side.

According to the first embodiment of the invention the coupling means can alternatively comprise a differential transformer with a first measurement coil for the input current and a second measurement coil for the output current of the same winding being wound around the same transformer core of the differential transformer.

According to any embodiment of the electrical machine the evaluation means can be configured for issuing a failure notice if a voltage value of the resulting signal exceeds a predefined threshold. This can be realized in that the evaluation means are configured to transform the resulting signal from the time domain into the frequency domain and to examine if the amplitude of the frequency component at the frequency of the power supply of the electrical machine exceeds a predefined threshold.

BRIEF DESCRIPTION OF FIGURES

The invention will be explained in closer detail by reference to preferred embodiments, which are depicted schematically in the figures.

Fig. 1     shows a possible general structure for an electrical machine according to the invention,

Fig. 2     shows a structure for an electrical machine for measuring the magnetic flux of the machine according to the second embodiment of the invention,

Fig. 3     shows a structure for an electrical machine according to the first embodiment of the invention with two measurement coils coupled in form of a differential transformer,

Fig. 4     shows a transformer core of Fig. 3.

WAYS TO IMPLEMENT THE INVENTION

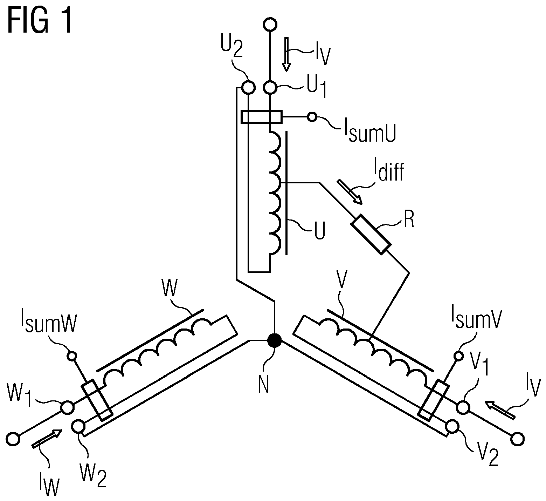

Fig. 1 shows the basic structure of a three phase electric motor with three power coils, i.e. windings (= phases) U,V,W which are connected at a neutral point N. Winding U carries the current $I_U$ which enters the winding via the input side $U_1$ and leaves the winding via the output side $U_2$. Winding V carries the current $I_V$ which enters the winding via the input side $V_1$ and leaves the winding via the output side $V_2$. Winding W carries the current $I_W$ which enters the winding via the input side $W_1$ and leaves the winding via the output side $W_2$.

For each winding U,V,W the sum of input current and output current $Isum_U$, $Isum_V$, $Isum_W$ is measured. In a healthy motor each of these sums of currents will be zero. Now if an insulation fault between windings U and V develops, which fault is represented by resistor R, the leakage current $I_{diff}$ will leave the motor via winding V and output side $V_2$, although it has entered the motor via winding U and input side $U_1$. Therefor a measurement of the sum $Isum_U$ of input current and output current of winding U carried out at both of the terminals at the input and output side $U_1,U_2$ will not yield zero. The leakage current $I_{diff}$ will be measured and read as a differential signal and can easily be detected according to the equation

$$I_{diff} = I_{Uin} - I_{Uout} \; ,$$

$I_{Uin}$ being the input current of winding U and $I_{Uout}$ being the output current of winding U.

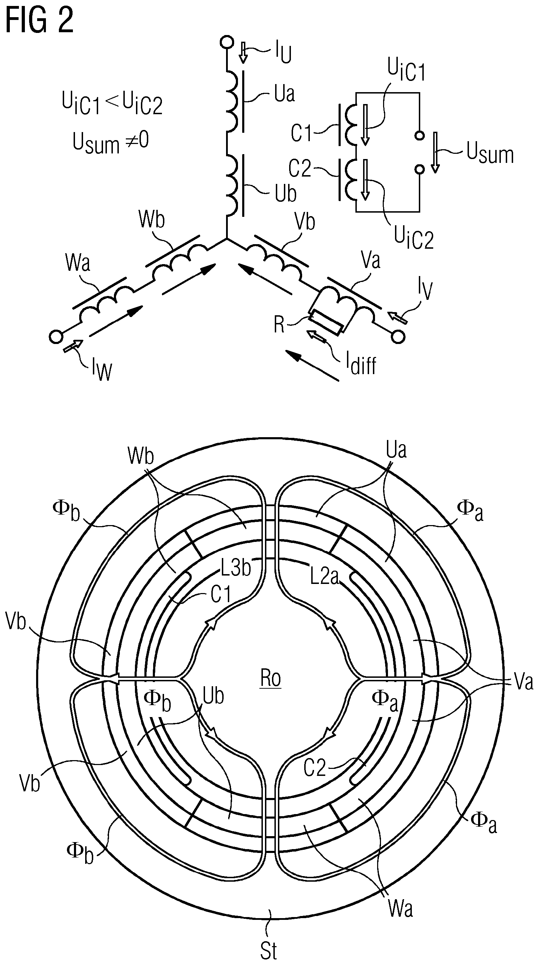

Similarly a current leaking from a winding U,V,W to earth will be detected in one phase differential reading. In this case the output side of the winding where the output current is measured is after the neutral point of the motor, see Fig. 2.

In any case, if there is a component of the leakage current $I_{diff}$ at the frequency of the motor's supply voltage, e.g. at 50 Hz, the winding insulation is faulty.

Fig. 2, according to the second embodiment of the invention, shows two measurement coils C1,C2 which are arranged symmetrically to the rotation axis of the rotor Ro of the machine, see the cross section of a motor in the right part of Fig. 2. The measurement coils C1,C2 are situated at the inner side of the Stator St, in this example closer to the rotor Ro than the windings Ua,Ub,Va,Vb,Wa,Wb. Each phase winding U,V,W is divided into two sub-windings Ua,Ub;Va,Vb;Wa,Wb. The left part of Fig. 2 shows the basic structure of the motor, similar to Fig. 1. The basic structure of the motor with three phase windings U,V,W is the same as in Fig. 1. Each winding U,V,W receives a supply voltage of approximately 380 V in this example.

To simulate a fault in the insulation, a resistor R representing the fault is connected in parallel to the sub-winding Va. The leakage current $I_{diff}$ (difference between input current and output current of winding V) is flowing through resistor R.

According to the second embodiment of the invention, the method consists of adding one or more pairs of additional winding coils C1,C2 into the electric motor winding Ua,Ub,Va,Vb,Wa,Wb. The pair C1,C2 is best wound symmetrically to the motor axis. The windings of each symmetrical pair are wound so that the magnetic flux $\Phi a,\Phi b$ of a healthy motor induces voltage UiC1 in measurement coil C1 and -UiC1 in C2. The resulting voltage when the two measurement coils are connected in series is + UiC1(t)- UiC1(t) = 0.

Since there is a failure in the insulation of the motor and therefore a leaking current $I_{diff}$ leaks through the winding Va, the currents $I_U,I_V,I_W$ do not produce an axis symmetrical magnetic flux in the motor anymore ($\Phi a$ is not equal to $\Phi b$). The voltages UiC1 in measurement coil C1 and UiC1 in measurement coil C2 are not equal and the winding fault can be detected if the voltage Usum = UiC1 - UiC2 exceeds a chosen threshold.

Whatever way the magnetic flux is measured in the motor, the quantity evaluated against a chosen threshold is proportional to the $\Phi_{sum} = \Phi a + \Phi b$ which in a healthy motor yields 0 because the fluxes are equal in amplitude and induce voltages into the additional windings with opposite signs (UiC1 + UiC2 = Usum = 0).

When the motor is in normal operation the voltage UiC1 induced in the measurement coil C1 differs from the voltage UiC2 induced in the measurement coil C2 only by the sign. So when the measurement coils C1,C2 are connected in series, as this is the case here, the resulting voltage Usum is zero.

When the winding Va is influenced by an insulation fault, the voltage induced in the measurement coil C1 differs from the voltage induced in the measurement coil C2 also in its absolute value because the motor's magnetic field is no longer symmetrical. As the measurement coils C1,C2 are connected in series the resulting voltage Usum will not be zero.

The signal resulting from the series connection of measurement coils C1,C2 can either be fed to a sensitive voltmeter or it is fed to a spectrum analyzer. In the latter case during evaluation of this resulting signal a FFT is applied to the signal and then the value at the frequency of 50 Hz, which is the frequency of the power supplied to the motor, is analyzed. Higher frequencies are parasitic deviations of the 50 Hz frequency or are created by rotating mechanical motor parts. These frequencies are not interesting in this case.

A pair of measurement coils C1,C2 could also be installed - alternatively or additionally - in other places of the machine (with another angle and/or another radius), e.g. covering the space between the measurement coils C1,C2 or additionally overlapping the measurement coils C1,C2 in circumferential direction.

The resulting signal of a pair of measurement coils C1,C2 can be evaluated separately for each pair, as depicted in Fig. 2, where there is one spectrum analyzer for measurement coils C1,C2.

It would also be possible to connect more than two measurement coils C1,C2 in series. The one and only resulting signal of these four measurement coils in series is led to a single spectrum analyzer (or to a single sensitive voltmeter). Or a first pair of measurement coils C1,C2 is connected to another pair of measurement coils C1,C2 in series. Again, the one and only resulting signal of these four measurement coils in series is led to a single spectrum analyzer (or to a single sensitive voltmeter).

It is also possible not only to send the resulting signal of a series connection of measurement coils C1,C2 directly to a spectrum analyzer, but also via a so called I to U transformer. In this case the I to U transformer would measure the current of the series connection.

Fig. 3 shows a structure for an electrical machine with two measurement coils coupled in the form of a differential transformer according to the first embodiment of the invention. Near a position where the input side $U_1,V_1,W1$ of one winding U,V,W is near to the output side $U_2,V_2,W2$ of the same winding U,V,W a transformer core T is installed. The transformer core T can have the form of a ring, see Fig. 4. The basic structure of the motor in Fig. 3 with three phase windings U,V,W is the same as in Fig. 1 and Fig. 2. Each winding U,V,W receives a supply voltage of approximately 380 V in this example.

To simulate a fault in the insulation, each winding U,V,W has two pins $X_1,X_2,X_3,X_4,X_5,X_6$ within the winding. Each pin can be connected to another pin via the resistor R representing the fault. For example winding U has two pins $X_2,X_5$ within the winding. Each pin $X_1,X_2,X_3,X_4,X_5,X_6$ can be connected to another pin or to the input sides $U_1,V_1,W_1$ of the windings via the resistor R representing the fault.

In this embodiment fault measurement is achieved by comparing input current $I_{Uin}$ and output current $I_{Uout}$ of the same winding U. This is done for each winding (power coil) U,V,W with a separate differential transformer having a transformer core T which is enclosed or wound by a power wire coil Pin carrying the whole input current $I_{Uin}$ and by another power wire coil $P_{out}$ carrying the whole output current $I_{Uout}$ of this winding U, see Fig. 4. Accordingly power wire coil Pin branches off from the power supply line leading to the winding U at the input side $U_1$ whereas power wire coil $P_{out}$ branches off from the winding U at the output side $U_2$.

The power wire coils $P_{in}$, $P_{out}$ are arranged on one side of the transformer core T at the same position so that their magnetic fields can superpose. On the other side of the transformer core T there is a transformer coil C which is connected to a voltage meter VM.

In case of no insulation fault between different windings U,V,W, that is in this example if winding U has no fault, input current $I_{Uin}$ and the output current $I_{Uout}$ of the same winding U is the same and their magnetic fields cancel each other. So no magnetic field acts on the transformer coil C and no voltage $V_{induct}$ is induced in the transformer coil C.

If there is a fault in the insulation of winding U then input current $I_{Uin}$ and output current $I_{Uout}$ are different, according to $I_{Uin} + I_{Uout} = I_{diff}$, and a magnetic field builds up around the power wire coils $P_{in}$, $P_{out}$, which magnetic field induces a voltage $V_{INDUCT}$ in the transformer coil C which can be detected by voltage meter VM. The induced voltage $V_{induct}$ is proportional to the leakage current $I_{diff}$ so in this case by directly measuring the induced voltage $V_{INDUCT}$ the measured voltage value is a measure for the leakage current $I_{diff}$. If this induced voltage $V_{INDUCT}$ is higher than a predefined value then a failure notice is issued by the evaluation software. Such fault in the insulation of winding U can be a short circuit to another winding V,W or to a grounded metal case of the motor.

Using electrical machines according to Fig. 1 to 4 with a supply voltage of 380 V leakage currents in the range of mA can be detected.

For all embodiments of the invention it is usually necessary to calibrate the measurement device, that is, the value of the resulting signal in case there is no failure has to be measured. Due to inaccuracies the resulting value of the healthy machine, e.g. Usum = UiC1 - UiC2 in the second embodiment or $I_{sum} = I_{in} + I_{out}$ in the first embodiment will not exactly be zero. To avoid that any small value that is not zero is regarded as fault, the result of the measurement of the healthy machine (or at least one machine of each machine type) is the lowermost threshold for the method according to the invention. So if the resulting signal of the healthy machine yields a value of x Volt then the predefined threshold has to be set at x+d Volt, d being greater than zero.

LIST OF REFERENCE SIGNS

| | |
|---|---|
| C | transformer coil |
| C1 | measurement coil |
| C2 | measurement coil |
| $I_{diff}$ | leakage current (difference between input current and output current) |
| $I_U$, $I_V$, $I_W$ | current in winding U,V,W |
| $I_{Uin}$ | input current of winding U |
| $I_{Uout}$ | output current of winding U |
| $Isum_U$, $Isum_V$, $Isum_W$ | sum of input current and output current of winding U,V,W |
| N | neutral point |
| $P_{in}$, $P_{out}$ | power wire coil (measurement coil) |
| R | resistor representing fault |
| Ro | rotor |
| SPEC | spectrum analyzer |
| St | stator |
| T | transformer core |
| U,V,W | winding (power coil) |
| $U_1,V_1,W_1$ | input side of the winding U,V,W |
| $U_2,V_2,W_2$ | output side of the winding U,V,W |
| Ua,Ub | sub-winding of winding U |
| UiC1 | voltage induced in coil C1 |
| UiC2 | voltage induced in coil C2 |
| Usum | resulting voltage |
| Va,Vb | sub-winding of winding V |
| Wa,Wb | sub-winding of winding W |
| $V_{INDUCT}$ | induced voltage |
| VM | voltage meter |
| $X_1,X_2,X_3,X_4,X_5,X_6$ | pins for connection to resistor R |

Φa,Φb                  magnetic flux

**Claims**

1.  Method for detection of failures in the windings (U,V,W) of an electrical machine, the method including the following steps:

    - measuring for a first area and for a second area of the windings different from the first area a physical quantity which is proportional to the electric current in the first area and in the second area, respectively,
    - coupling the measured electrical signal representing the current ($I_{Uin}$) in the first area with the measured electrical signal representing the current ($I_{Uout}$) in the second area,
    - obtaining a resulting electric signal proportional to the difference ($I_{diff}$) of both currents,
    - issuing a failure notice if a value of the resulting signal exceeds a predefined threshold.

2.  Method according to claim 1, **characterized in that** the physical quantity which is proportional to the electric current is the voltage, especially the voltage induced in a coil (C1,C2,$P_{in}$,$P_{out}$,C).

3.  Method according to claim 1 or 2, the method including the following steps:

    - measuring for the input side ($U_1$,$V_1$,$W_1$) and for the output side ($U_2$,$V_2$,$W_2$) of the same winding a physical quantity which is proportional to the electric current on the input side and on the output side, respectively,
    - coupling the measured electrical signal representing the input current ($I_{Uin}$) with the measured electrical signal representing the output current ($I_{Uout}$),
    - obtaining a resulting electric signal proportional to the difference ($I_{diff}$) of input current and output current,
    - issuing a failure notice if a value of the resulting signal exceeds a predefined threshold.

4.  Method according to claim 3, **characterized in that** for coupling the measured electrical signal representing the input current ($I_{Uin}$) with the measured electrical signal representing the output current ($I_{Uout}$) a first measurement coil at the input side and a second measurement coil at the output side being connected in series are used.

5.  Method according to claim 3, **characterized in that** for coupling the measured electrical signal representing the input current ($I_{Uin}$) with the measured electrical signal representing the output current ($I_{Uout}$) a first measurement coil ($P_{in}$) for the input current and a second measurement coil ($P_{out}$) for the output current of the same winding are wound around the same transformer core (T) to implement a differential transformer.

6.  Method according to claim 1 or 2, the method including the following steps:

    - measuring a first magnetic flux (Φa) for a first area of the windings (U,V,W) and a second magnetic flux (Φb) for a second area of the windings (U,V,W) which second area - in relation to the axis of the electrical machine - is situated symmetrical to the first area,
    - coupling the measured electrical signal (UiC2) representing the magnetic flux (Φa) in the first area with the measured electrical signal (UiC1) representing the magnetic flux (Φb) in the second area,
    - obtaining a resulting electric signal (Usum) proportional to the difference of first and second magnetic flux,
    - issuing a failure notice if a value of the resulting signal (Usum) exceeds a predefined threshold.

7.  Method according to any of the preceding claims, **characterized in that** the value of the resulting signal (Usum) is a voltage.

8.  Method according to claim 5, **characterized in that** the resulting signal (Usum) is transformed from the time domain into the frequency domain and the amplitude of the frequency component at the frequency of the power supply of the electrical machine is examined if it exceeds a predefined threshold.

9.  Electrical machine for detection of failures in its windings, for carrying out a method according to one of the claims 1 to 8, the machine including at least

    - measuring means configured for measuring for a first area and for a second area of the windings (U,V,W) different from the first area a physical quantity which is proportional to the electric current in the first area and in the second area, respectively,
- coupling means configured for coupling the measured electrical signal representing the current ($I_{Uin}$) in the first area with the measured electrical signal representing the current ($I_{Uout}$) in the second area, and for obtaining a resulting electric signal proportional to the difference ($I_{diff}$) of both currents,
- evaluation means configured for issuing a failure notice if a value of the resulting signal exceeds a predefined threshold.

10. Electrical machine according to claim 9, the machine including at least

- measuring means ($P_{in}$,$P_{out}$) configured for measuring for the input side and for the output side of the same winding (U,V,W) a physical quantity which is proportional to the electric current on the input side and on the output side, respectively,
- coupling means (T, C) configured for coupling the measured electrical signal representing the input current ($I_{Uin}$) with the measured electrical signal representing the output current ($I_{Uout}$), and for obtaining a resulting electric signal proportional to the difference ($I_{diff}$) of input current and output current,
- evaluation means (VM) configured for issuing a failure notice if a value of the resulting signal exceeds a predefined threshold.

11. Electrical machine according to claim 9, the machine including at least

- measuring means (C1,C2) configured for measuring a first magnetic flux ($\Phi a$) for a first area of the windings and a second magnetic flux ($\Phi b$) for a second area of the windings (U,V,W) which second area - in relation to the axis of the electrical machine - is situated symmetrical to the first area,
- coupling means configured for coupling the measured electrical signal representing the magnetic flux ($\Phi a$) in the first area with the measured electrical signal representing the magnetic flux ($\Phi b$) in the second area, and for obtaining a resulting electric signal (Usum) proportional to the difference of first and second magnetic flux,
- evaluation means configured for issuing a failure notice if a value of the resulting signal exceeds a predefined threshold.

12. Electrical machine according to any of claims 9 to 11, **characterized in that** the measuring means comprise coils (C1,C2,$P_{in}$,$P_{out}$,C).

13. Electrical machine according to claims 10 and 12, **characterized in that** the coupling means comprise a series connection of a first measurement coil at the input side and a second measurement coil at the output side.

14. Electrical machine according to claims 10 and 12, **characterized in that** the coupling means comprise a differential transformer with a first measurement coil ($P_{in}$) for the input current and a second measurement coil ($P_{out}$) for the output current of the same winding being wound around the same transformer core (T) of the differential transformer.

15. Electrical machine according to any of claims 9 to 14, **characterized in that** the evaluation means are configured for issuing a failure notice if a voltage value of the resulting signal exceeds a predefined threshold.

FIG 1

# FIG 2

FIG 3

EP 3 413 066 A1

FIG 4

Europäisches
Patentamt

European
Patent Office

Office européen
des brevets

**EUROPEAN SEARCH REPORT**

Application Number

EP 17 17 4719

## DOCUMENTS CONSIDERED TO BE RELEVANT

| Category | Citation of document with indication, where appropriate, of relevant passages | Relevant to claim | CLASSIFICATION OF THE APPLICATION  (IPC) |
|---|---|---|---|
| X | WO 2013/136098 A1 (KONCAR INST ZA ELEKTROTEHNIKU D D [HR]) 19 September 2013 (2013-09-19) * page 6, line 15 - page 12, line 25 * ----- | 1,2,6,7, 9,11,12, 15 | INV. G01R31/34 ADD. G01R31/14 |
| X | US 4 136 312 A (SALON SHEPPARD J ET AL) 23 January 1979 (1979-01-23) * column 2, line 49 - column 4, line 32; figures 1-4 * ----- | 1,9 | |
| X | GB 1 470 375 A (ASS ELECT IND) 14 April 1977 (1977-04-14) * page 2, line 9 - page 3, line 113; figures 1-5 * ----- | 1,9 | |
| A | EP 0 552 991 A2 (ONTARIO HYDRO [CA]) 28 July 1993 (1993-07-28) * abstract; figure 5 * ----- | 1,9 | |

TECHNICAL FIELDS
SEARCHED      (IPC)

G01R

~~The present search report has been drawn up for all claims~~

| Place of search | Date of completion of the search | Examiner |
|---|---|---|
| Munich | 30 November 2017 | Hijazi, Ali |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

          .....................................................................................

& : member of the same patent family, corresponding
    document

EPO FORM 1503 03.82 (P04C01)

**Europäisches Patentamt**
**European Patent Office**
**Office européen des brevets**

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

6, 11(completely); 1, 2, 7, 9, 12, 15(partially)

☐ The present supplementary European search report has been drawn up for those parts of the European patent application which relate to the invention first mentioned in the claims (Rule 164 (1) EPC).

**Europäisches Patentamt**
**European Patent Office**
**Office européen des brevets**

## LACK OF UNITY OF INVENTION
## SHEET B

Application Number

EP 17 17 4719

The Search Division considers that the present European patent application does not comply with the requirements of unity of invention and relates to several inventions or groups of inventions, namely:

1. claims: 6, 11(completely); 1, 2, 7, 9, 12, 15(partially)

   Method and electrical machine for detecting insulation fault within a winding of a motor
   ---

2. claims: 3-5, 8, 10, 13, 14(completely); 1, 2, 7, 9, 12, 15(partially)

   Method and electrical machine for detecting insulation fault between windings of a motor or between a winding and earth
   ---

## ANNEX TO THE EUROPEAN SEARCH REPORT
## ON EUROPEAN PATENT APPLICATION NO.

EP 17 17 4719

This annex lists the patent family members relating to the patent documents cited in the above-mentioned European search report.
The members are as contained in the European Patent Office EDP file on
The European Patent Office is in no way liable for these particulars which are merely given for the purpose of information.

30-11-2017

| Patent document cited in search report | | Publication date | Patent family member(s) | | Publication date |
|---|---|---|---|---|---|
| WO 2013136098 | A1 | 19-09-2013 | HR P20120245 A2 | | 30-09-2013 |
| | | | WO 2013136098 A1 | | 19-09-2013 |
| US 4136312 | A | 23-01-1979 | BE 862244 A | | 23-06-1978 |
| | | | FR 2376418 A1 | | 28-07-1978 |
| | | | JP S5384101 A | | 25-07-1978 |
| | | | US 4136312 A | | 23-01-1979 |
| GB 1470375 | A | 14-04-1977 | NONE | | |
| EP 0552991 | A2 | 28-07-1993 | AT 186988 T | | 15-12-1999 |
| | | | CA 2086641 A1 | | 24-07-1993 |
| | | | DE 69327066 D1 | | 30-12-1999 |
| | | | DE 69327066 T2 | | 08-06-2000 |
| | | | EP 0552991 A2 | | 28-07-1993 |
| | | | US 5252915 A | | 12-10-1993 |

EPO FORM P0459

For more details about this annex : see Official Journal of the European Patent Office, No. 12/82